# EUROPÄISCHE PATENTSCHRIFT

(11) **EP 0 681 420 B1**
(45) Veröffentlichungstag und Bekanntmachung des Hinweises auf die Patenterteilung: **15.04.1998**
(21) Anmeldenummer: 95102126.0
(22) Anmeldetag: 16.02.1995
(51) Int. Cl.: H05K 7/14, H05K 5/00, H05K 5/02

(54) **Gehäuse, insbesondere zur Aufnahme elektrischer oder elektronischer Bauteile**
Housing for electric and electronic components in particular
Boîtier notamment pour abriter des composants électriques et électroniques

(30) Priorität: 06.05.1994 DE 4416004
(43) Veröffentlichungstag der Anmeldung: 08.11.1995
(73) Patentinhaber: Bernstein, Hans-Joachim, D-32479 Hille (DE)
(72) Erfinder: Wecke, Rolf, Dipl.-Ing., D-31675 Bückeburg (DE); Weiss, Jürgen, D-32312 Lübbecke (DE)
(74) Vertreter: Stracke, Alexander, Dipl.-Ing.

(56) Entgegenhaltungen:
- FR-A- 1 408 204
- GB-A- 2 157 086
- US-A- 4 673 100

## Beschreibung

Die vorliegende Erfindung betrifft ein aus einem Unterteil und einem damit über mindestens zwei Halteelemente lösbar verbundenen Deckel bestehendes Gehäuse, insbesondere zur Aufnahme elektrischer oder elektronischer Bauteile.

Gehäuse der vorerwähnten Art sind in vielerlei Ausführungsformen bekannt, siehe z.B. FR 1 408 204.

Um in einem derartigen Gehäuse untergebrachte Bauteile, insbesondere elektronische oder elektrische Bauteile gegen äußere Einflüsse zu schützen, wird zwischen Unterteil und Dekkel eine umlaufende Dichtung angeordnet, die durch das Schließen des Gehäuses - also durch das Verbindung von Unterteil und Deckel - in gewissen Grenzen zusammengepreßt werden muß.

Um die hierfür erforderlichen Kräfte aufzubringen, sind bislang als Halteelemente zur Verbindung von Deckel und Unterteil vorzugsweise Schrauben verwendet worden. Es sind auch Halteelemente bekannt, die aus federbelasteten Bolzen bestehen, die durch entsprechende Durchgangsbohrungen hindurchgesteckt und durch Verdrehen gesichert werden, wobei durch die Federwirkung ein Zusammenziehen von Unterteil und Deckel bewirkt wird.

Die vorgenannten Möglichkeiten zur Verbindung von Deckel und Unterteil erfordern sowohl beim Schließen wie auch beim Öffnen eines entsprechend gestalteten Gehäuses bestimmte Werkzeuge, außerdem sind meist kostspielige Bearbeitungsvorgänge am Unterteil und/oder Deckel erforderlich, wie beispielsweise das Schneiden von Gewinden oder das Einsetzen von Gewindebolzen.

Der vorliegenden Erfindung liegt die Aufgabe zugrunde, ein Gehäuse der gattungsgemäßen Art zu schaffen, welches sich durch eine besonders einfache Art der Verbindung zwischen Unterteil und Deckel auszeichnet.

Diese Aufgabe wird erfindungsgemäß dadurch gelöst, daß als Halteelemente Klemmbügel vorgesehen sind, die jeweils zwei fest miteinander verbundene Klemmstege aufweisen, welche auf an den Außenseiten vom Unterteil und Deckel angebrachte Auflager aufgeklemmt sind und diese klammerartig zusammenziehen.

Die für diese Art der Verbindung von Unterteil und Deckel erforderlichen Auflager können bei der Herstellung von Unterteil und Deckel gleich einstückig mit den vorgenannten Teilen angeformt werden, so daß diesbezüglich keine zusätzlichen Kosten oder Montagearbeiten oder Nachbearbeitungen erforderlich sind. Die Klemmbügel selbst können beispielsweise als einfache Kunststoffspritzteile ebenfalls preiswert hergestellt werden. Die Verbindung von Unterteil und Deckel erfordert lediglich das Aufschieben dieser Klemmbügel auf die am Unterteil und am Deckel vorgesehenen Auflager, wodurch dann das Zusammenpressen von Unterteil und Deckel bewirkt wird. Besondere Werkzeuge sind hierfür nicht erforderlich, das gleiche gilt für das Entfernen der Klemmbügel, wenn das Gehäuse einmal geöffnet werden soll.

Die Auflager können die Form von Vorsprüngen oder von Enbuchtungen aufweisen.

Weitere Merkmale der Erfindung sind Gegenstand von Unteransprüchen.

In den beigefügten Zeichnungen sind Ausführungsbeispiele der Erfindung dargestellt, die im folgenden näher beschrieben werden. Es zeigen:
- Figur 1: eine perspektivische Darstellung eines erfindungsgemäßen Gehäuses im geöffneten Zustand,
- Figur 2: eine perspektivische Darstellung eines mehrteiligen Gehäuses im geöffneten Zustand nach einem weiteren Ausführungsbeispiel der Erfindung,
- Figur 3: eine Teildraufsicht auf einen Eckbereich des Gehäuses gemäß Figur 1 im geschlossenen Zustand,
- Figur 4: eine Ansicht in Richtung des Pfeiles IV in Figur 3,
- Figur 5: eine Teilansicht eines Eckbereiches des Gehäuses nach Figur 1 bei geöffneter Abdeckklappe des Öffnungsbereiches,
- Figur 6: eine Ansicht in Richtung des Pfeiles VI in Figur 5,
- Figur 7: eine Teilansicht eines Eckbereiches des Gehäuses nach Figur 1 in Öffnungsstellung des Verschlußmechanismus unter Weglassung der in den Figuren 5 und 6 gezeigten Abdeckklappe,
- Figur 8: eine Ansicht in Richtung des Pfeiles VIII in Figur 7,
- Figur 9: eine der Figur 7 entsprechende Teilansicht mit zusätzlich dargestellter Abdeckklappe,
- Figur 10: eine Ansicht in Richtung des Pfeiles X in Figur 9,
- Figur 11: eine teilweise im Schnitt gezeigte Ansicht eines Eckbereiches des Gehäuses nach Figur 1 in vollständig geschlossenem Zustand,
- Figur 12: eine Ansicht in Richtung des Pfeiles XII in Figur 11.

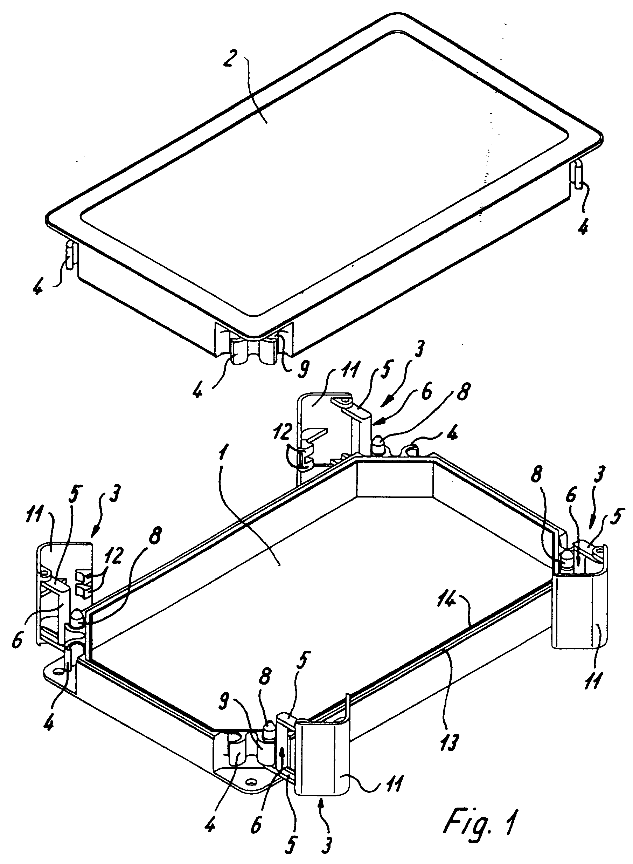

In Figur 1 ist mit dem Bezugszeichen 1 ein Unterteil eines Gehäuses gezeichnet, welches durch einen Deckel 2 verschließbar ist und beispielsweise zur Aufnahme von elektrischen oder elektronischen Bauteilen dient.

Das Unterteil 1 und der Deckel 2 sind vorteilhafterweise einstückig aus Kunststoff hergestellt.

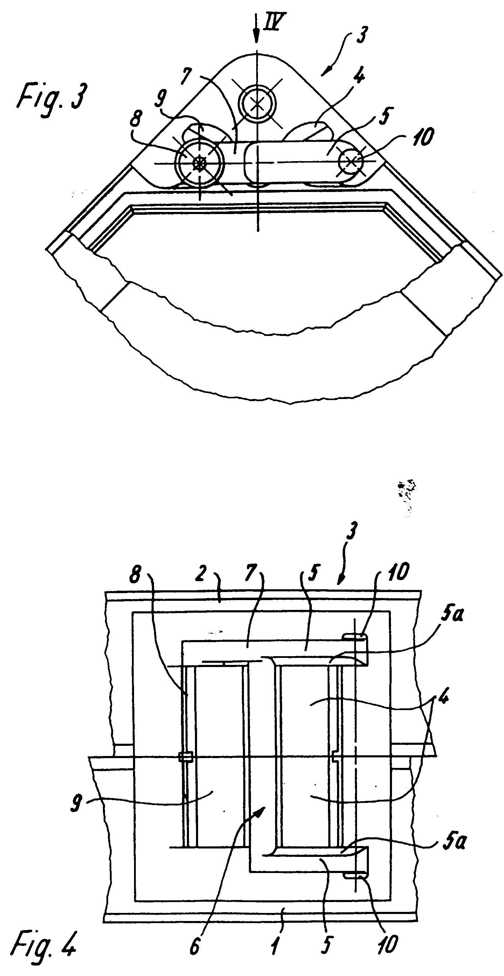

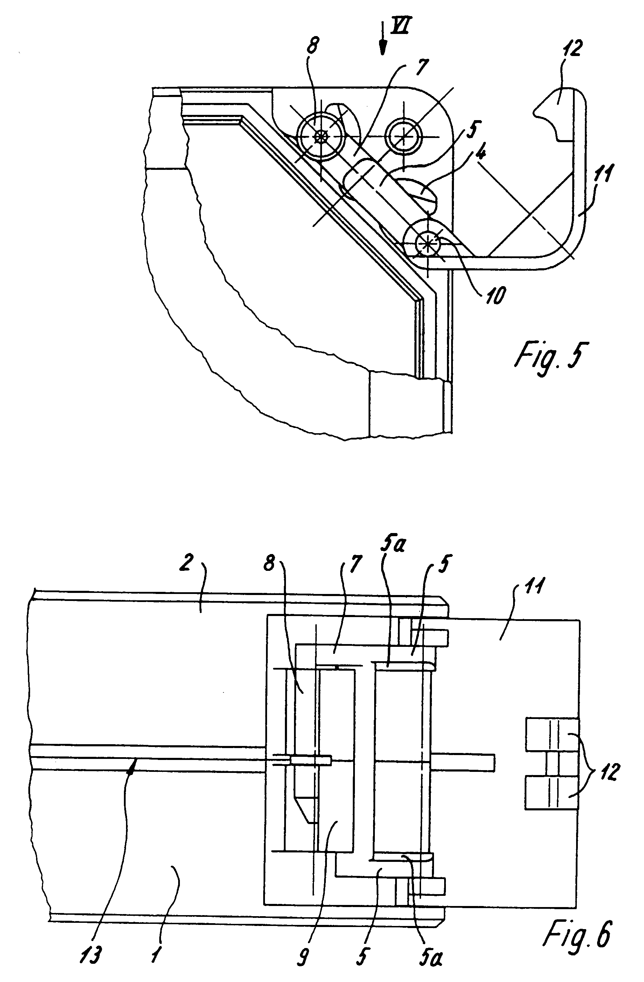

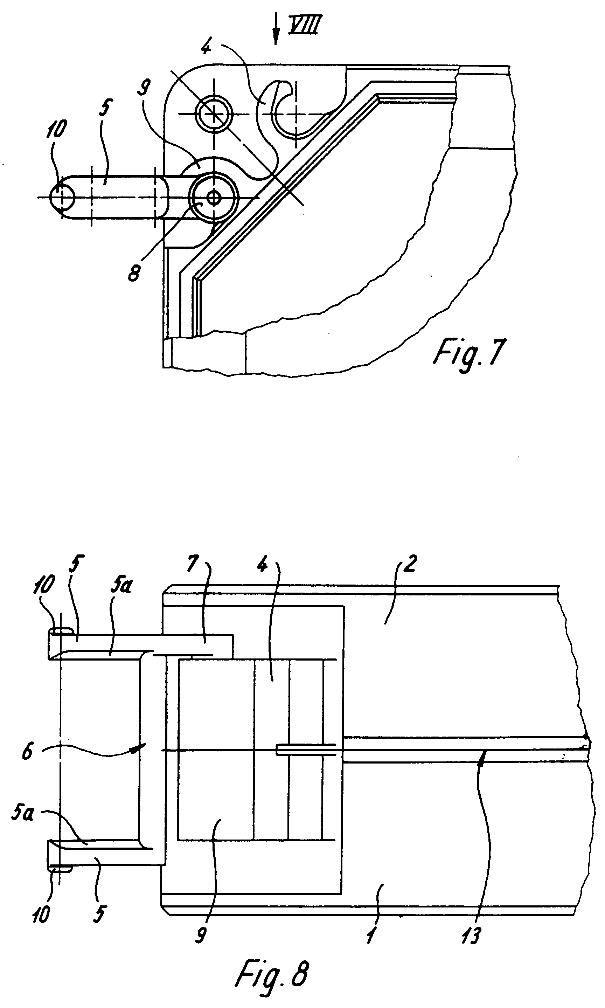

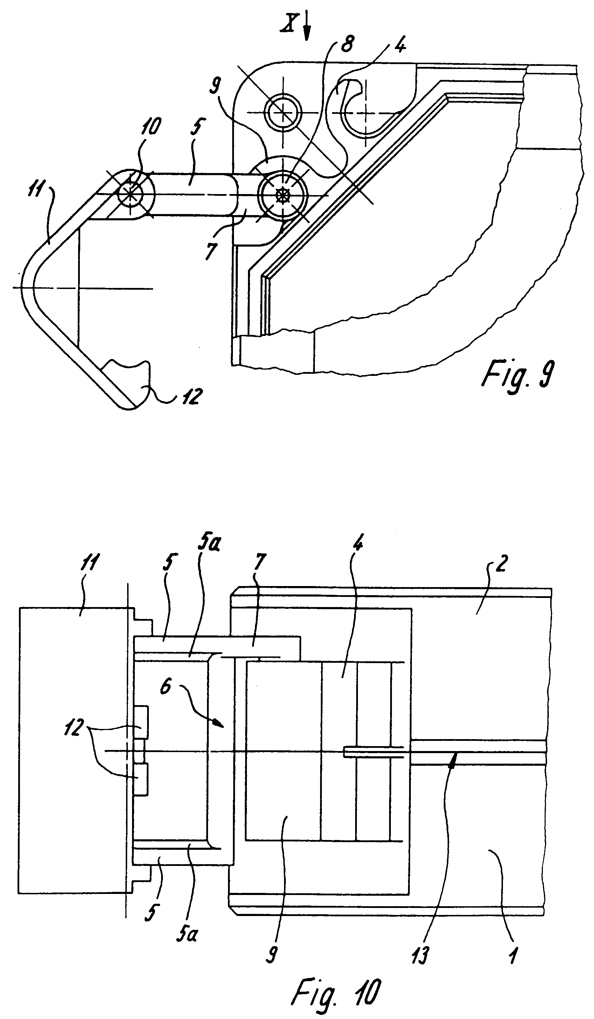

Die Grundrißform des Unterteiles 1 und des Deckels 2 sind rechteckig. In den Eckbereichen von Unterteil 1 und Deckel 2 sind Verschlußmechanismen 3 angeordnet, die hinsichtlich ihres Aufbaues und ihrer Wirkungsweise insbesondere unter Bezugnahme auf die Figuren 3 bis 12 im folgenden näher beschrieben werden.

Vorab sei darauf hingewiesen, daß die Verschlußmechanismen 3 an allen vier Eckbereichen identisch sind, so daß im folgenden immer nur von einem Verschlußmechanismus 3 die Rede ist.

Wie sich aus den Zeichnungen eindeutig ergibt, sind am Unterteil 1 und am Deckel 2 jeweils nach außen vorstehende Auflager in Form von Vorsprügen 4 angeformt, die im geschlossenen Zustand des Gehäuses von Klemmstegen 5 eines Klemmbügels 6 übergriffen und fest zusammengeklemmt sind. Die Klemmstege 5 des Klemmbügels 6 sind fest miteinander verbunden und liegen im Schließzustand auf den Außenseiten der erwähnten Vorsprünge 4 auf und ziehen diese Vorsprünge 4 und damit das Unterteil 1 und dem Deckel 2 klammerartig zusammen. Die Schließposition ergibt sich besonders anschaulich aus den Figuren 3 und 4.

Um das Aufschieben der Klemmstege 5 auf die Vorsprünge 4 unter Erreichung einer Schließkraft zu erleichtern, sind die Klemmstege 5 im Bereich ihrer Seitenflanken mit Abschrägungen 5a versehen, so daß diese Klemmstege 5 bequem auf die zunächst noch in einem größeren Abstand als im endgültigen Schließzustand zueinanderliegenden Außenflächen der Vorsprünge 4 aufgeschoben werden können.

Abweichend vom dargestellten Ausführungsbeispiel besteht auch die Möglichkeit, die Auflager für die Klemmstege 5 statt durch Vorsprünge durch entsprechende Einbuchtungen im Unterteil 1 bzw. im Deckel 2 zu bilden.

Die Klemmstege 5 verlaufen parallel zur Trennebene 13 zwischen Unterteil 1 und Deckel 2, so daß die größtmöglichen Schließkräfte bei aufgeschobenem Klemmbügel erzielt werden.

Die Klemmbügel 6 sind auf der den Klemmstegen 5 gegenüberliegenden Seite mit einem Ausleger 7 versehen, der einen Lagerzapfen 8 trägt. Dieser Lagerzapfen 8 ist jeweils in eine in einem Abstand zum benachbarten Vorsprung 4 befindliche Halblagerschale 9 eingeklemmt. Diese Halblagerschale 9 weist die gleiche Form auf wie der benachbarte Vorsprung 4, so daß ein jeder Klemmbügel 6 gegenüber der in Figur 1 gezeigten Position auch in den gegenüberliegenden Vorsprung 4 eingeklemmt werden könnte.

Durch den Lagerzapfen 8 kann der Klemmbügel 6 geschwenkt werden, und zwar derart, daß sich zum Zwecke des Verbindens von Unterteil 1 und Deckel 2 die Klemmstege 5 in der schon erwähnten Art und Weise über die Vorsprünge 4 legen oder daß die erwähnten Klemmstege 5 in die aus Figur 1 ersichtliche Öffnungsstellung verbracht werden können.

Wie aus den Zeichnungen weiter hervorgeht, sind an den freien Enden der Klemmstege 5 außenseitig Lagerstutzen 10 angeformt, auf denen jeweils eine Abdeckkappe 11 schwenkbar gelagert ist. Diese Abdeckkappe 11, die als Winkelstück ausgebildet ist und im geschlossenen Zustand die vollständige Rechteckform des Gehäuses gewährleistet, ist an ihrem freien Ende mit Rastnocken 12 ausgestattet, die im Schließzustand den jeweiligen Lagerzapfen 8 rastend hintergreifen.

Die Verbindung von Unterteil 1 und Deckel 2 geschieht also wie folgt:

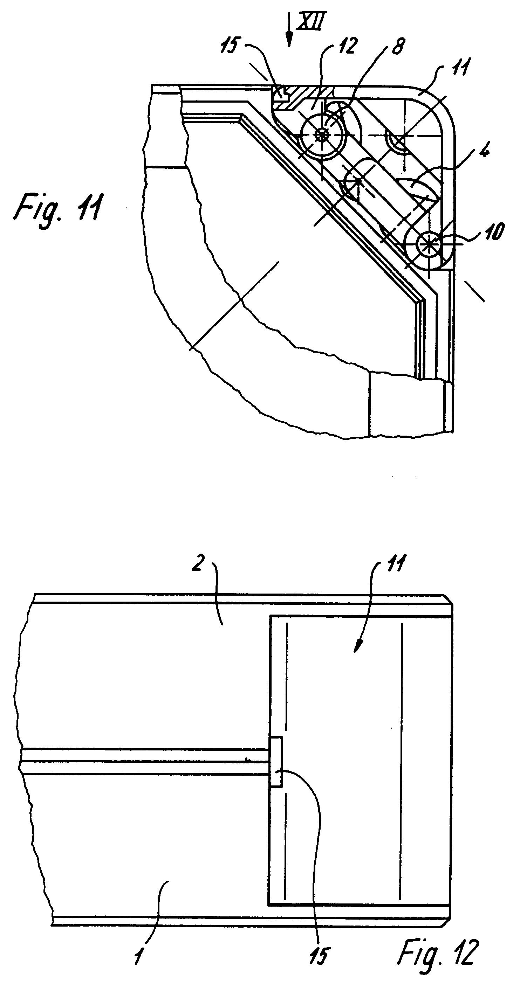

Zunächst werden in allen Eckbereichen die Klemmbügel 6 mit ihrem Lagerzapfen 8 in eine Halblagerschale 9 eingeklemmt und in die aus Figur 1 ersichtliche Position geschwenkt. In dieser Stellung kann der Deckel 2 behinderungsfrei auf das Unterteil 1 aufgesetzt werden. Nun werden die Klemmbügel 6 um den jeweiligen Lagerzapfen 8 derart verschwenkt, daß die Klemmstege 5 die benachbarten Vorsprünge 4 übergreifen und diese zusammenziehen, wodurch auch der entsprechende Anpreßdruck auf eine in der Trennebene 13 angebrachte, umlaufende Dichtung 14 aufgebracht wird. Anschließend werden die Abdeckkappen 11 eingeschwenkt und mit ihrem Rastnocken 12 an den jeweiligen Lagerzapfen 8 festgelegt. Es ergibt sich dann die aus den Figuren 11 und 12 ersichtliche gültige Schließstellung.

Zum Zwecke des Öffnens des Gehäuses ist in umgekehrter Reihenfolge vorzugehen, d. h., zunächst sind alle Abdeckklappen 11 aufzuschwenken, anschließend werden die Klemmbügel so weit verschwenkt, daß die Klemmstege außer Eingriff mit den Vorsprügen 4 sind. Dann kann der Deckel 2 behinderungsfrei vom Unterteil 1 abgenommen werden.

Sowohl für das Öffnen wie auch für das Schließen sind keine speziellen Werkzeuge erforderlich, ebenso sind am Unterteil 1 und am Deckel 2 keine besonderen Montagearbeiten oder Nachbearbeitungen notwendig. Die Vorsprünge 4 bzw. die Halblagerschalen 9, die vorteilhafterweise identisch ausgebildet sind, werden schon bei der Herstellung von Unterteil 1 und Deckel 2 an diese Teile angeformt.

Die Klemmbügel 6 und die Abdeckklappe 11 sind vorteilhafterweise ebenfalls aus Kunststoff hergestellt und können demzufolge leicht und preiswert miteinander verbunden werden.

Um das Öffnen der Abdeckklappen 11 zu erleichtern, ist im Bereich der Rastnocken 12 eine von außen zugängliche Aussparung 15 vorgesehen, in die beispielsweise ein Schraubendreher oder ein anderes einfaches Werkzeug eingesteckt werden kann, um die jeweilige Abdeckklappe 11 aus ihrer Raststellung herauszubewegen.

Die Vorsprünge 4 und die identisch gestalteten Halblagerschalen 9 sind jeweils im abgeschrägten Eckbereich von Unterteil 1 und Deckel 2 angebracht, und dabei symmetrisch zueinander angeordnet, bezogen sowohl auf eine lotrechte wie auch auf eine waagerechte Ebene. Somit ist es, worauf schon hingewiesen wurde, möglich, die Klemmbügel 6 in beliebiger Position am Unterteil 1 oder auch am Deckel 2 anzuordnen.

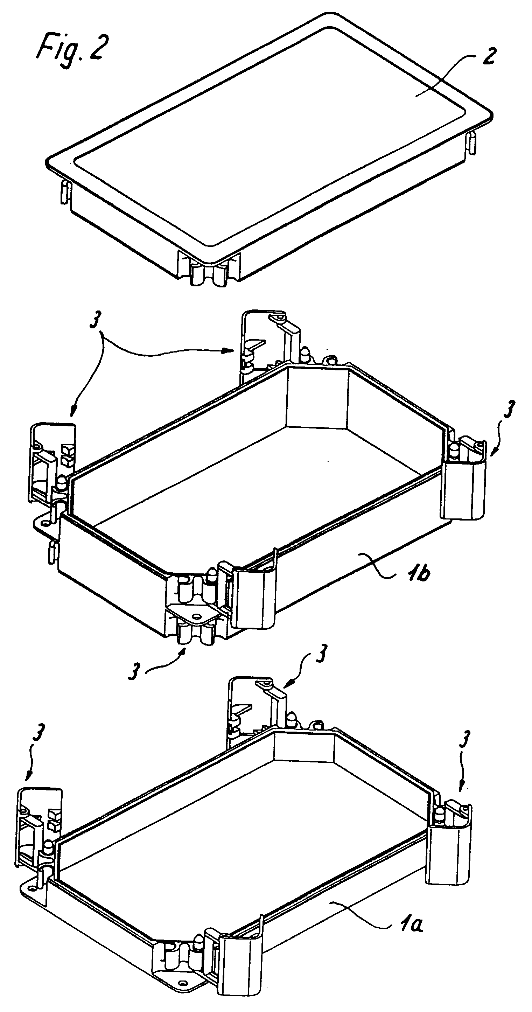

Bei dem Ausführungsbeispiel gemäß Figur 2 ist gezeigt, daß das gesamte Gehäuse auch aus einem zweiteiligen Unterteil bestehen kann. Das Unterteil ist in diesem Falle gebildet aus einem kastenartigen Bauteil la, welches dem Unterteil 1 nach der Figur 1 entspricht und einem Aufsatzrahmen 1b, der in der gleichen Weise mit dem Bauteil la verbunden ist wie der Dekkel beim Ausführungsbeispiel nach Figur 1.

Der Aufsatzrahmen 1b ist an der dem Deckel 2 zugewandten Oberseite wieder mit zusätzlichen Verschlußmechanismen 3 versehen, die wieder in der schon beschriebenen Art und Weise die Verbindung mit dem Deckel 2 ermöglichen.

Es versteht sich, daß über das Ausführungsbeispiel der Figur 2 hinausgehend ein weiterer Aufsatzrahmen 1 aufgesetzt werden könnte, um die Gesamthöhe des Gehäuses zu vergrößern.

In jedem Falle erfolgt die Verbindung zwischen einem Bauteil la und einem Aufsatzrahmen 1b in der gleichen Weise wie die Verbindung zwischen einem Gehäuse-Unterteil 1 und einem Dekkel 2 und mit den gleichen Mitteln, so daß eine erneute, ausführliche Beschreibung dieser Verbindungstechnik und der dafür erforderlichen Mittel entbehrlich ist.

## Patentansprüche

1. Aus einem Unterteil und einem damit über mindestens zwei Halteelemente lösbar verbundenen Deckel bestehendes Gehäuse, insbesondere zur Aufnahme elektrischer oder elektronischer Bauteile, **dadurch gekennzeichnet**, daß als Halteelemente Klemmbügel (6) vorgesehen sind, die jeweils zwei fest miteinander verbundene Klemmstege (5) aufweisen, welche auf an den Außenseiten von Unterteil (1) und Deckel (2) angebrachte Auflager (4) aufgeklemmt sind und diese klammerartig zusammenziehen.

2. Gehäuse nach Anspruch 1, dadurch gekennzeichnet, daß die Klemmstege (5) parallel zur Trennebene (13) zwischen Unterteil (1) und Deckel (2) verlaufen.

3. Gehäuse nach Anspruch 1 oder 2, dadurch gekennzeichnet, daß die Auflager durch am Unterteil (1) und Deckel (2) angebrachte Vorsprünge (4) gebildet sind.

4. Gehäuse nach einem der Ansprüche 1 bis 3, dadurch gekennzeichnet, daß die Klemmstege (5) in ihrem Seitenflankenbereichen mit Abschrägungen (5a) versehen sind.

5. Gehäuse nach einem der Ansprüche 1 bis 4, dadurch gekennzeichnet, daß jeder Klemmbügel (6) mit einem den Klemmstegen (5) abgewandt liegenden Ausleger (7) versehen ist, der einen Lagerzapfen (8) trägt und mittels dieses Lagerzapfens (8) in eine am Unterteil (1) oder am Deckel (2) angeformte Halblagerschale (9) eingeschnäppt ist.

6. Gehäuse nach einem der Ansprüche 2 bis 5, dadurch gekennzeichnet, daß die Vorsprünge (4) und die Halblagerschalen (9) formgleich ausgebildet sind.

7. Gehäuse nach Anspruch 6, dadurch gekennzeichnet, daß die Vorsprünge (4) und die Halblagerschalen (9) sowohl lotrecht wie auch parallel zur Trennebene (13) symmetrisch zueinander ausgebildet sind.

8. Gehäuse nach einem oder mehreren der vorhergehenden Ansprüche, dadurch gekennzeichnet, daß die Klemmstege (5) an ihren freien Enden mit Lagerstutzen (10) versehen sind, auf denen jeweils eine Abdeckklappe (11) schwenkbar gelagert ist, die an ihrem freien Ende mit Rastnokken (12) versehen ist, die im geschlossenen Zustand den jeweils zugeordneten Lagerzapfen (8) hintergreifen.

9. Gehäuse nach Anspruch 5, dadurch gekennzeichnet, daß jede Abdeckklappe (11) benachbart ihrer Rastnocken (12) außenseitig mit einer Aussparung (15) versehen ist.

10. Gehäuse nach einem oder mehreren der vorhergehenden Ansprüche, dadurch gekennzeichnet, daß Unterteil (1) und Deckel (2) in an sich bekannter Weise einen rechteckigen Grundriß aufweisen und daß die Vorsprünge (4) und die Halblagerschalen (9) jeweils an abgeschrägten Eckbereichen angeformt sind und daß die jeweils mit den Klemmstegen (5) verbundene Abdeckklappe (11) im Schließzustand die Eckabschrägung von Unterteil (1) und Deckel (2) ausfüllt.

11. Gehäuse nach einem oder mehreren der vorhergehenden Ansprüche, dadurch gekennzeichnet, daß zwischen Unterteil (1) und Deckel (2) mindestens ein Aufsatzrahmen (1b) angeordnet ist, der mit dem Unterteil (1a) ebenso über Klemmbügel (6) verbunden ist wie der Deckel (2) mit den Aufsatzrahmen (1b).

## Claims

1. A housing comprising a lower portion and a cover which is releasably connected thereto by way of at least two holding elements, in particular for receiving electrical or electronic components, characterised in that the holding elements are in the form of clamping stirrup members (6) which each have two fixedly interconnected clamping legs (5) which are clamped on to supports (4) disposed on the outsides of the lower portion (1) and the cover (2) and pull them together in a clip-like manner.

2. A housing according to claim 1 characterised in that the clamping legs (5) extend parallel to the plane of separation (13) between the lower portion (1) and the cover (2).

3. A housing according to claim 1 or claim 2 characterised in that the supports are formed by projections (4) disposed on the lower portion (1) and the cover (2).

4. A housing according to one of claims 1 to 3 characterised in that the clamping legs (5) are provided with bevels (5a) in their side flank regions.

5. A housing according to one of claims 1 to 4 characterised in that each clamping stirrup member (6) is provided with a cantilever arm (7) which faces away from the clamping legs (5) and which carries a mounting projection (8) and which is fitted with snapping engagement by means of the mounting projection (8) into a half-mounting shell (9) formed on the lower portion (1) or on the cover (2).

6. A housing according to one of claims 2 to 5 characterised in that the projections (4) and the half-mounting shells (9) are of the same shape.

7. A housing according to claim 6 characterised in that the projections (4) and the half-mounting shells (9) are of a symmetrical configuration relative to each other both perpendicularly and also parallel to the plane of separation (13).

8. A housing according to one or more of the preceding claims characterised in that at their free ends the clamping legs (5) are provided with mounting stud portions (10), on which there is pivotably mounted a respective cover flap (11) which is provided at the free end with retaining projections (12) which in the closed condition engage behind the respectively associated mounting projections (8).

9. A housing according to claim 5 characterised in that adjacent its retaining projections (12) each cover flap (11) is provided on its outside with a recess (15).

10. A housing according to one or more of the preceding claims characterised in that the lower portion (1) and the cover (2) are of a rectangular shape in plan in per se known manner and that the projections (4) and the half-mounting shells (9) are each formed at respective bevelled corner regions and that the cover flap (11) which is respectively connected to the clamping legs (5), in the closed condition, fills the corner bevelling of the lower portion (1) and the cover (2).

11. A housing according to one or more of the preceding claims characterised in that arranged between the lower portion (1) and the cover (2) is at least one attachment frame (1b) which is connected to the lower portion (1a) by way of clamping stirrup members (6) just as the cover (2) is connected to the attachment frame (1b).

## Revendications

1. Boîtier constitué d'une partie inférieure et d'un couvercle relié à celui-ci, de manière amovible, par au moins deux éléments de maintien, destiné en particulier à recevoir des composants électriques ou électroniques, caractérisé en ce que sont prévus en tant qu'éléments de maintien des étriers de serrage (6), qui comportent chacun deux pattes de serrage (5), reliées fixement entre elles, qui sont pincées sur des supports (4), fixés sur les côtés extérieurs de la partie inférieure (1) et du couvercle (2) et qui serrent ensemble ceux-ci à la manière d'une agrafe.

2. Boîtier selon la revendication 1, caractérisé en ce que les pattes de serrage (5) sont parallèles au plan de séparation (13) entre la partie inférieure (1) et le couvercle (2).

3. Boîtier selon la revendication 1 ou 2, caractérisé en ce que les supports sont formés par des saillies (4), fixées sur la partie inférieure (1) et le couvercle (2).

4. Boîtier selon l'une des revendications 1 à 3, caractérisé en ce que les pattes de serrage (5) sont pourvues de chanfreins (5a), dans leurs zones des flancs latéraux.

5. Boîtier selon l'une des revendications 1 à 4, caractérisé en ce que chaque étrier de serrage (6) est pourvu d'un bras (7), tourné à l'opposé des pattes de serrage (5), qui porte un tourillon (8) et qui est encliqueté, au moyen de ce tourillon (8), dans une demi-coque de palier (9), réalisée sur la partie inférieure (1) ou sur le couvercle (2).

6. Boîtier selon l'une des revendications 2 à 5, caractérisé en ce que les saillies (4) et les demi-coques de palier (9) sont de forme identique.

7. Boîtier selon la revendication 6, caractérisé en ce que les saillies (4) et les demi-coques de palier (9) sont symétriques entre elles, aussi bien verticalement que parallèlement au plan de séparation (13).

8. Boîtier selon une ou plusieurs des revendications précédentes, caractérisé en ce que les pattes de serrage (5) sont pourvues, à leurs extrémités libres, d'appuis de palier (10), sur chacun desquels est monté pivotant un capot (11), qui est pourvu, à son extrémité libre, de cames d'encliquetage (12), qui à l'état fermé, passent derrière le tourillon (8) correspondant respectif.

9. Boîtier selon la revendication 5, caractérisé en ce que chaque capot (11) est pourvu d'une découpe (15), sur le côté extérieur, au voisinage de ses cames d'encliquetage (12).

10. Boîtier selon une ou plusieurs des revendications précédentes, caractérisé en ce que la partie inférieure (1) et le couvercle (2) présentent, de façon connue en soi, une projection horizontale rectangulaire et en ce que les saillies (4) et les demi-coques de palier (9) sont réalisées chacune sur des zones d'angle chanfreinées et en ce que le capot (11), relié aux pattes de serrage (5) remplit, à l'état de fermeture, le chanfrein d'angle de la partie inférieure (1) et du couvercle (2).

11. Boîtier selon une ou plusieurs des revendications précédentes, caractérisé en ce qu'entre la partie inférieure (1) et le couvercle (2) est disposé au moins un cadre rapporté (1b), qui est relié avec la partie inférieure (1b) par des étriers de serrage (6), tout comme le couvercle (2) avec le cadre rapporté (1b).
